# EUROPEAN PATENT SPECIFICATION

(11) **EP 1 818 376 B1**
(45) Date of publication and mention of the grant of the patent: **28.10.2009**
(21) Application number: 07002732.1
(22) Date of filing: 08.02.2007
(51) Int. Cl.: C09D 11/10, G03F 7/038, G03F 7/027

(54) **Photosensitive composition**
Lichtempfindliche Zusammensetzung
Composition photosensible

(30) Priority: 08.02.2006 JP 2006031452
(43) Date of publication of application: 15.08.2007
(60) Divisional application: 08006868.7
(73) Proprietor: KABUSHIKI KAISHA TOSHIBA, Tokyo 105-8001 (JP); Toshiba TEC Kabushiki Kaisha, Tokyo 141-8664 (JP)
(72) Inventor: Ishibashi, Mitsuru, 1-chome, Minato-ku Tokyo 105-8001 (JP); Ushirogouchi, Toru, 1-chome, Minato-ku Tokyo 105-8001 (JP); Kiyomoto, Hiroshi, Intell. Prop. Div., Tokyo 141-8664 (JP); Akiyama, Ryozo, Intell. Prop. Div., Tokyo 141-8664 (JP); Kawakami, Yukiko, Intell. Prop. Div., Tokyo 141-8664 (JP); Ohtsu, Kazuhiko, Intell. Prop. Div., Tokyo 141-8664 (JP)
(74) Representative: Kramer - Barske - Schmidtchen

(56) References cited:
- EP-A- 1 528 088
- EP-A- 1 696 008
- EP-A- 1 705 230
- JP-A- 2001 181 385
- US-A1- 2004 167 315
- US-A1- 2006 019 077

## Description

This invention relates to a photosensitive composition and to a composite member and electronic parts wherein the photosensitive composition is employed.

In recent years, due to the trend to further miniaturize electronic equipment, the manufacture of electronic parts by printing is now being attempt. With circuit boards in particular, enhanced fineness and multiplication of pattern layers is demanded to further increase pattern density. To meet this demand, there have been proposed various methods for forming a conductive layer and an insulating layer on a circuit board by a printing method such as screen printing, off set printing, or inkjet printing, etc. In the conventional method of forming a conductive body, a wiring pattern is first printed using ink, is then heated or left to stand to evaporate a solvent, and finally is thermally sintered. The pattern layer thus formed however often fails to attain sufficient adhesion to the circuit board.

The manufacture, by printing, of electronic parts and composite members other than circuit boards has been also proposed. In particular, the manufacture of a liquid crystal display substrate or an EL display substrate is now being attempted.

There have been a number of proposals to employ a photosensitive resin in the printing process because of the advantage that printed layers can be cured rapidly without the need for a drying step. However, conventional photosensitive inks are insufficient in adhesion to metals and poor in solvent resistance. In an attempt to manufacture electronic parts such as a circuit board by printing, printing a conductive substance on the surface of a resin layer is now being attempted. If it is possible to employ a photosensitive resin which is not only excellent in adhesion to metals but also sufficiently high in mechanical strength, it may be possible to form a laminated structure consisting of an insulating material and a conductive material all by printing. However, such a photosensitive resin has yet to be discovered.

Additionally, in recent years, there has been increasing consumer concern over environmental problems and product safety, so that it is imperative to consider the safety of the photosensitive resin carefully. In the case of ink using a photosensitive resin of cationic polymerization type, epoxy compounds are generally employed as a polymeric monomer. These epoxy compounds however are not necessarily safe from a mutagenic viewpoint, since many of them give a positive reaction in the AMES test (a reverse mutation test using bacteria). The kinds of epoxy resins which give a negative reaction in the AMES test are considerably limited and all of them are insufficient in adhesion to metals or curability.

Although there has been proposed an ink employing an epoxy compound which gives a negative reaction in the AMES test, the ink is inferior in solvent resistance if a large quantity of alicyclic epoxy compound is used therein.

US 2006/0019077 A1 relates to a process for making a printed circuit board having a solder mask and (an) area(s) of exposed metal circuitry, which comprises the steps of applying a nonaqueous ink, which is substantially free from organic solvent, to a printed circuit board, curing the ink by exposure to actinic radiation, and optionally heating the ink, whereby the ink is applied to selected areas of the printed circuit board by means of an inkjet printer, and wherein the ink comprises a cationically curable compound and a cationic initiator.

EP 1 528 088 A1 and EP 1 705 230 A1 disclose an inkjet ink, comprising a photo-acid generating agent, which is capable of generating an acid as it is irradiated with light, a color component, and an acid-polymerizable compound which can be polymerized in the presence of an acid, wherein at least 40 % of the acid-polymerizable solvent is a vinyl ether compound.

EP 1 696 008 A1 relates to a dispersion for an ink, which includes a dispersion medium, a powder or pigment having an average particle diameter of not more than 300 nm, a polymer dispersing agent containing a first resinous dispersing agent and a second resinous dispersing agent, and an ionic compound.

JP 2001-181385 A discloses a cationically polymerizable coloring composition, comprising an oxetane compound and a cationic polymerisation initiator.

US 2004/0167315 A1 discloses an active energy ray curable composition, which may comprise an oxetane compound having one or more oxetane rings, a vinyl ether compound and a cationic photopolymerization initiator.

In order to avoid the above disadvantages, the present invention provides a photosensitive composition according to claim 1 and a composite member according to claim 13. Further developments of the present invention are set out in the dependent claims.

The invention can be more fully understood from the following detailed description when taken in conjunction with the accompanying drawings, in which:
FIG. 1 is a cross-sectional view illustrating one of the steps in the manufacturing method of the composite member according to one embodiment;
FIG. 2 is a plan view of the composite member according to another embodiment;
FIGS. 3A to 3E are cross-sectional views each illustrating the manufacturing method of the composite member according to another embodiment;
FIG. 4 is a plan view of the composite member according to a further embodiment;
FIG. 5 is a diagram schematically illustrating the construction of a printing apparatus to be employed in the manufacture of the composite member according to a further embodiment; and
FIG. 6 is a cross-sectional view illustrating one of the steps in the manufacturing method of the composite member according to a still further embodiment.

Next, embodiments will be explained as follows.

A photosensitive composition according to one embodiment comprises a specific kind of organic dispersion medium and a cationic photopolymerization initiator. More specifically, the organic dispersion medium contains at least one kind of vinyl ether compound. at least one kind of oxetane compound and an oxirane compound.

As the oxetane compound, it is possible to employ a compound having two oxetane rings or compound having one oxetane ring. Examples of the compound having two oxetane rings includedi[1-ethyl(3-oxetanyl)] methyl ether,
1,4-bis[1-ethyl-3-oxetanyl)methoxy] benzene,
1,3-bis[1-ethyl-3-oxetanyl)methoxy] benzene,
4,4'-bis[(3-ethyl-3-oxetanyl)methoxy] biphenyl,
1,4-bis{[(3-ethyl-3-oxetanyl)methoxy]methyl} benzene, bis[(1-ethyl-3-oxetanyl)methoxy] cyclohexane, and bis[(1-ethyl-3-oxetanyl)methoxy] norbornane. As examples of the compound having one oxetane ring, they include, for example, 3-ethyl-3-(phenoxymethyl) oxetane, 3-ethyl-3-(2-ethylhexyloxymethyl) oxetane, 3-ethyl-3-hydroxymethyl oxetane,
[(1-ethyl-3-oxetanyl)methoxy] cyclohexane, and oxetanyl silsesquioxane. Further, it is also possible to employ acrylic compound having, on its side chain, an oxetane group, and methacrylic compound having, on its side chain, an oxetane group. When these compounds are incorporated in the organic dispersion medium, the viscosity of the photosensitive composition can be prevented from being increased and at the same time, it is possible to expect almost the same curing rate-accelerating effect as that of oxetane compound.

In order to enhance the adhesion of the photosensitive composition to a substrate formed of various metals such as SUS, copper and aluminum; plastic materials such as polyethylene terephthalate (PET), polypropylene (PP) and polycarbonate (PC); or glass, it is preferable to employ 3-ethyl-3-(phenoxymethyl) oxetane.

The employment of a bifunctional oxetane compound is useful for providing a photosensitive composition which is further improved in solvent resistance of the cured product thereof. This oxetane compound may be used singly or in combination of two or more.

As the vinyl ether compound, vinyl ether compounds represented by the following general formula (1) are employed:

R¹¹-R¹²-(R¹¹)ₚ (1)

(in this general formula (1), R¹¹s are individually a group selected from the group consisting of a vinyl ether group, a vinyl ether skeleton-bearing group, an alkoxy group, a substituted hydroxyl group and hydroxyl group, at least one of R¹¹s being a vinyl ether group or a vinyl ether skeleton-bearing group; R¹² is a (p+1)-valent group having a substituted or unsubstituted cyclic ether skeleton; and p is a positive integer including zero).

A vinyl ether compound which is bonded to the methylene group of aliphatic glycol derivative or cyclohexane dimethanol is generally well known. The polymerization reaction of a vinyl ether compound of this kind is greatly obstructed by the presence of powder. Moreover, because of relatively high viscosity of this kind of vinyl ether compound, a photosensitive composition comprising this kind of vinyl ether compound and powder has been conventionally considered difficult to prepare. In the vinyl ether compound represented by the aforementioned general formula (1), at least one vinyl ether group is linked directly to a cyclic ether compound. Therefore, even if the vinyl ether compound is incorporated into a photosensitive composition together with powder, the photosensitive composition is enabled to exhibit excellent curing property.

According to the present invention, cyclic ether compounds having a substituent group including a vinyl ether structure are used as the vinyl ether compound. In viewpoint of curability and safety, a compound having a cyclic ether skeleton containing not only five-membered ring skeleton having oxygen atom but also a bridged structure or a spiro structure is most preferable. These vinyl ether compounds can be suitably synthesized using, as starting materials, corresponding alcohol compounds and vinyl ether source such as vinyl acetate or propenyl ether and by a method which converts alcohol into vinyl ether using a catalyst such as iridium chloride (see J. Am. Chem. Soc. Vol. 124, No. 8, 1590-1591 (2002)).

Among the compounds mentioned above, the employment of epoxy compounds, oxetane compounds and vinyl ether compounds each having an abundantly existing skeleton in nature such as a terpenoid skeleton or a norbornane skeleton is preferable in the respect of manufacturing cost.

Preferred examples of such cyclic ether compounds include the compounds represented by the following chemical formulas:

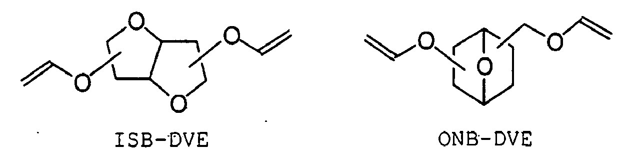

As example of the vinyl ether compounds having none of the aforementioned cyclic ether structure, there is generally well known a vinyl compound having a poly(alkylene glycol) skeleton and exhibiting a relatively low volatility. For example, because of low cost, triethylene glycol divinyl ether is widely employed as such a vinyl ether compound. When a vinyl ether compound having none of the aforementioned cyclic ether structure is incorporated in the photosensitive composition, the adhesion of the photosensitive composition to a substrate degrades considerably. Moreover, the ultimate hardness of the photosensitive composition is also more likely to be degraded. Because of these reasons, the vinyl ether compound should preferably be selected from those having the aforementioned cyclic ether skeleton.

The cyclic ether compound having a substituent group containing the aforementioned vinyl ether structure is incorporated in the dispersion medium at a content of not less than 30% based on the weight of the dispersion medium. When the content of the cyclic ether compound is less than 30% based on the weight of the dispersion medium, the hardness of the cured coated film of the photosensitive composition may be degraded and also the solvent resistance thereof may become insufficient.

The aforementioned vinyl ether compound may be employed singly or in combination of two or more.

A least one of the aforementioned oxetane compound and the aforementioned specific kinds of vinyl ether compound is required to be a monofunctional compound. When a monofunctional compound is included in the photosensitive composition, the shrink characteristics of cured film to be obtained can be controlled. Namely, when the monofunctional compound is appropriately incorporated in the dispersion medium, the shrinkage to be generated in the curing process of the acid-polymerizable compound can be suppressed, resulting in the enhancement of adhesion of the cured film. The content of the monofunctional compound is confined to the range of 20 to 70% by weight based on a total weight of the organic dispersion medium. If the content of the monofunctional compound is less than 20% by weight, it may become difficult to form a cured film which is excellent in adhesion to a substrate. On the other hand, if the content of the monofunctional compound exceeds 70% by weight, the hardness of the cured film to be obtained may become insufficient, thus raising problems. Preferably, the content of the monofunctional compound should be confined to the range of 30 to 50% by weight based on a total weight of the organic dispersion medium.

The organic dispersion medium to be incorporated in the photosensitive composition according to the present invention further contains an oxirane compound in addition to the oxetane compound and the vinyl ether compound. As the oxirane compound, it is possible to employ any kinds of compounds which can be generally employed as epoxy resin. As examples of the oxirane compound, they include monomer, oligomer and polymer of aromatic epoxide, alicyclic epoxide and aliphatic epoxide.

Examples of the oxirane compound include alicyclic epoxy compounds such as Celloxide 2021, Celloxide 2021A, Celloxide 2021P, Celloxide 2081, Celloxide 2000 and Celloxide 3000 (all available from Daicel Chemical Industries Ltd.); (metha)acrylate compounds having epoxy group, such as Cyclomer A200 and Cyclomer M100; methacrylate having methylglycidyl group such as MGMA; glycidol representing a low molecular epoxy compound; β-methylepichlorohydrin; α-pinene oxide; α-olefin monoepoxide having 12 to 14 carbon atoms; α-olefin monoepoxide having 16 to 18 carbon atoms; epoxidized soy bean oil such as Dimac S-300K; epoxidized linseed oil such as Dimac L-500; and polyfunctional epoxy compounds such as Epolead GT301 and Epolead GT401. Further, it is also possible to employ alicyclic epoxy compounds (such as Cylacure; Dow Chemical Co., Ltd, U.S.); low molecular weight phenol compounds which are hydrogenated and aliphatized with terminal hydroxyl group thereof being substituted by a group having epoxy; glycidyl ether of polyhydric aliphatic alcohol/alicyclic alcohol such as ethylene glycol, glycerin, neopentyl alcohol, hexanediol and trimethylol propane; glycidyl ether of hexahydrophthalic acid; and glycidyl esters of hydrogenated aromatic polyhydric carboxylic acid.

Especially, epoxy compounds having an alicyclic skeleton can be preferably employed, since it is possible, with the employment of such epoxy compounds, to secure a some degree of high boiling point and low viscosity in addition to the high reactivity thereof.

Further, as the epoxy compound which is not so high in mutagenicity in the AMES test, it is preferable to employ those which are not so small in molecular weight. Namely, alicyclic epoxy compounds such as Celloxide 3000 can be preferably employed. Incidentally, an alicyclic epoxy compound having a molecular weight ranging from 150 to 300 is preferable for use. If the molecular weight of the alicyclic epoxy compound is less than 150, the mutagenicity thereof may become higher. On the other hand, if the molecular weight of the alicyclic epoxy compound is higher than 300, the storage stability of the alicyclic epoxy compound is more likely to be degraded.

The content of the oxirane compound is confined to not more than 30% based on a total weight of the dispersion medium. More preferably, the content of the oxirane compound should be confined to the range of 3 to 20% by weight. When the content of the oxirane compound is confined to this range, it is possible to obtain a photosensitive composition which is capable of forming a cured film which is excellent in adhesion to a substrate and in solvent resistance.

The content of the oxetane compound is confined to the range of 20 to 60% based on a total weight of the organic dispersion medium. Using a photosensitive composition comprising the organic dispersion medium containing these oxirane compound and oxetane compound at the aforementioned contents, it is possible to form a cured film which is not degraded in adhesion and is further improved in film strength.

The oxirane compound or the oxetane compound should preferably be formed of a monofunctional compound. When any of these compounds employed is monofunctional, the adhesion of a cured film to be obtained can be further enhanced. An oxetane compound having a cyclic skeleton is most preferable as the monofunctional compound.

For example, a photosensitive composition comprising 20 to 40% by weight of a monofunctional oxetane compound, 10 to 30% by weight of a bifunctional oxetane compound, 3 to 20% by weight of an oxirane compound, and 30 to 50% by weight of a vinyl ether compound is capable of forming a cured film having high mechanical strength and is especially excellent in solvent resistance.

When a bifunctional oxetane compound is incorporated in the organic dispersion medium, the degree of crosslinking of the cured film will be increased, thereby greatly enhancing the solvent resistance thereof. When the content of bifunctional oxetane compound is not less than 18% by weight and the content of monofunctional oxetane compound is not more than 30% by weight, the cured film may not be sufficiently adhered to a substrate immediately after the heating subsequent to the irradiation of light, provided that condition of the heating after the irradiation of light is confined to 120°C or less. Namely, a sufficient adhesion of the cured film can be developed only when the cured film is left to stand for several days. For example, when a stereostructure such as microlens is manufactured using a mold, the releasability of the stereostructure would become excellent, thus facilitating the manufacture of the stereostructure. Additionally, the stress due to the cure shrinkage can be alleviated, thereby making it possible to advantageously suppress the warpage or deformation of cured products.

The aforementioned components of the organic dispersion medium which are useful herein are mainly selected from those indicating negativity in the AMES test from the viewpoint of safety. However, if the quantity is limited, components indicating positivity in the AMES test may be employed while making it possible to retain the negativity of the photosensitive composition in the AMES test.

In addition to the aforementioned organic dispersion medium, a cationic photopolymerization initiator is incorporated as an essential component of the photosensitive composition according to this embodiment. This cationic photopolymerization initiator, which is also called, in general, a photo-acid generating agent, is formed of a compound which is capable of generating an acid when it is irradiated with light. As this cationic photopolymerization initiator, onium salts are most preferably employed. Examples of onium salts useful herein include diazonium salts, phosphonium salts, sulfonium salts and iodonium salts having, as a counter ion, fluoroboric acid anion, hexafluoroantimonic acid anion, hexafluoroarsenic acid anion, trifluoromethane sulfonate anion, paratoluene sulfonate anion, paranitrotoluene sulfonate anion, halogen-based anion, sulfonic acid-based anion, carboxylic acid-based anion, or sulfate anion. Among these onium salts, it is more preferable, from the viewpoints of the safety of photosensitive composition and environmental consideration, to select those having an anion species which does not include boron, antimony or arsenic.

More specific examples of such onium salts are compounds represented by the following chemical formulas.

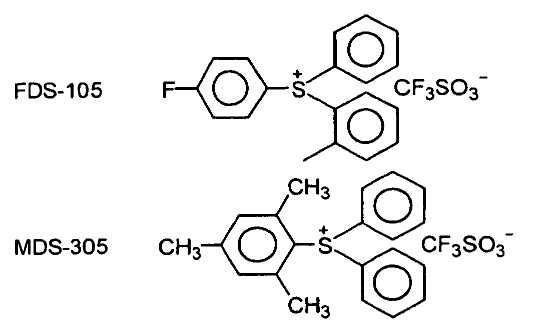

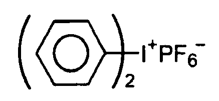

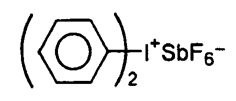

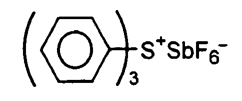

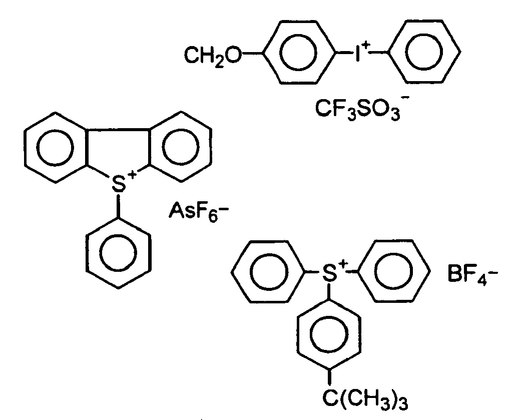

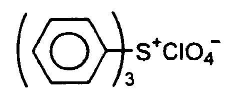

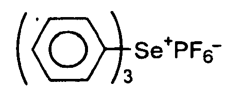

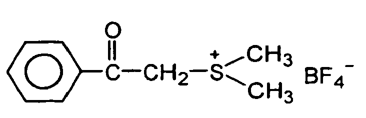

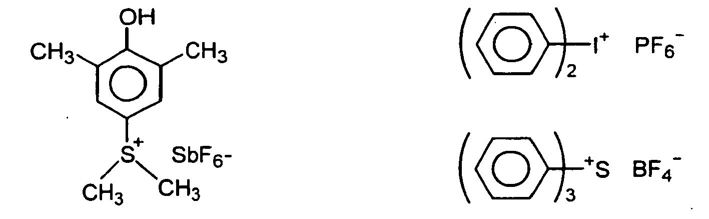

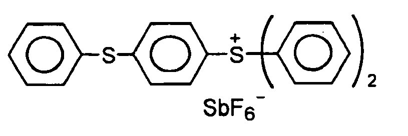

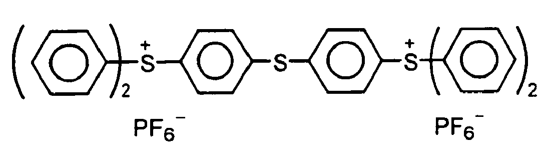

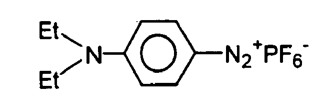

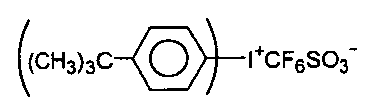

[C₆H₅Fe⁺C₆H₅]PF₆⁻

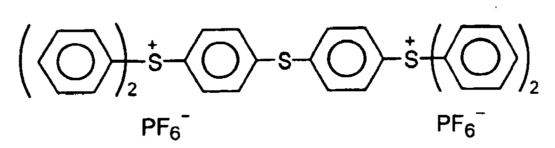

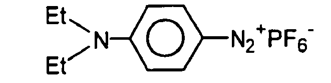

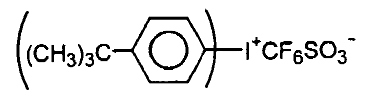

[C₆H₅Fe⁺C₆H₅]PF₆⁻

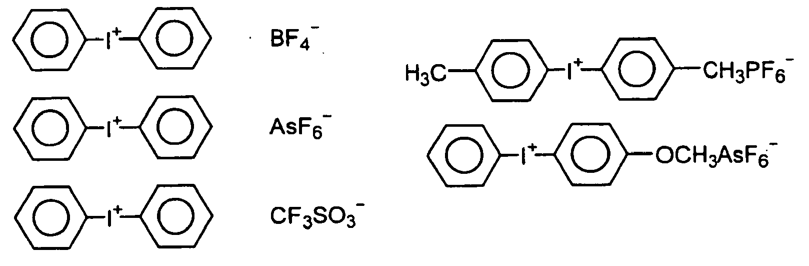

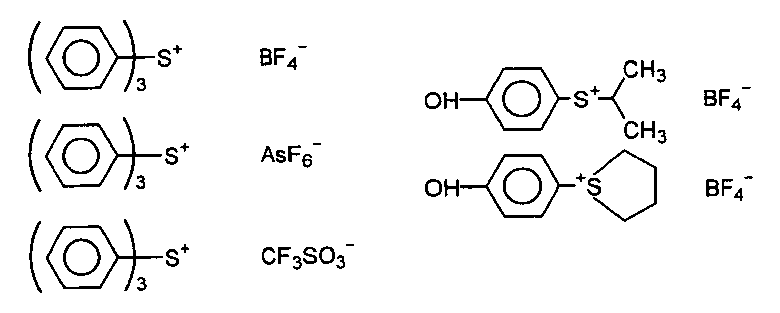

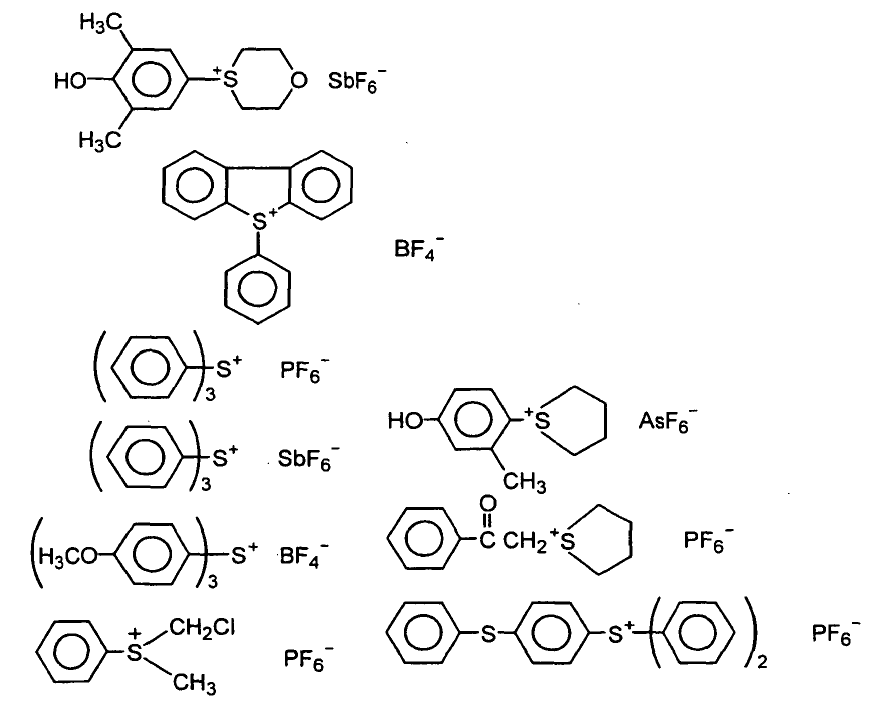

Examples of onium salts available in the market are, for example, MPI-103 (CAS No. [87709-41-9]; Midori Kagaku Co., Ltd.), BDS-105 (CAS No. [145612-66-4]; Midori Kagaku Co., Ltd.), NDS-103 (CAS No. [110098-97-0]; Midori Kagaku Co., Ltd.), MDS-203 (CAS No. [127855-15-5]; Midori Kagaku Co., Ltd.), DTS-102 (CAS No. [75482-18-7]; Midori Kagaku Co., Ltd.), DTS-103 (CAS No. [71449-78-0]; Midori Kagaku Co., Ltd.), MDS-103 (CAS No. [127279-74-7]; Midori Kagaku Co., Ltd.), MDS-105 (CAS No. [116808-67-4]; Midori Kagaku Co., Ltd.), MDS-205 (CAS No. [81416-37-7]; Midori Kagaku Co., Ltd.), BMS-105 (CAS No. [149934-68-9]; Midori Kagaku Co., Ltd.), TMS-105 (CAS No. [127820-38-6]; Midori Kagaku Co., Ltd.), Uvacure 1591 and 1590 (Daicel UCB Co, Ltd.); UVI-6992 and 6976 (Dow Chemical Co., Ltd.), Esacure-1064 (Lamberty Co., Ltd.); and Irgacure 250 (Ciba-Geigy Co., Ltd.).

Among the aforementioned onium salts, sulfonium salt and iodonium salt are more excellent in stability. However, it is known that due to the process in the manufacture of these onium salts, these onium salts are unavoidably formed of a mixture comprising monovalent salt (a salt consisting of monovalent cation and one anion) and up to about 75% of not less than divalent salt (a salt consisting for example of bivalent cation and a couple of anions), so that the products of these onium salts available in the market are also formed of such a mixture of onium salts. This trend becomes more prominent in the case of sulfonium salts. It is known that when a multivalent salt is included in the photosensitive composition, the photosensitive wavelength thereof is enabled to shift toward longer wavelength side, thereby generally rendering the photosensitive composition to become higher in sensitivity. With a view to take advantage of this merit, a salt of not less than bivalency is sometimes deliberately incorporated in the ink. For example, Uvacure 1591 and 1590 (Daicel UCB Co, Ltd.), UVI-6992 and 6976 (Dow Chemical Co., Ltd.), Esacure-1064 (Lamberty Co., Ltd.), etc. are produced based on such a concept. However, multivalent salts may badly affect the flocculation stability of the powder to be included in the photosensitive composition. More specifically, the employment of multivalent salts may lead to the generation of a weak linkage between powder particles and a dispersant, thereby giving rise to the generation of gelling or flocculation. Therefore, the restriction of the presence of these multi-valent salts in the photosensitive composition to as minimum as possible would generally lead to the improvement of the dispersion stability of powder particles.

Therefore, generally speaking, the content of multivalent onium salt should preferably be confined to not more than 20% based on a total weight of all of onium salts. More preferably, the content of multivalent onium salt should be confined to 5% by weight or less. Most preferably, multivalent onium salt should not be included in the photosensitive composition.

Since fluorophosphates salt of aryl sulfonium and fluorophosphates salt of aryl iodonium are very excellent in enhancing flocculation stability of powder among the aforementioned onium salts, the employment of these fluorophosphates salts is preferable. Even in the case of monovalent onium salts, they are capable of gradually substituting, with time, for a terminal amine resin employed as a dispersant if the dispersant become insufficient. Therefore, it is desirable that onium salts should be constructed such that they cannot be easily moved into the joint portion between the surface of powder and the terminal of dispersant. This can be realized using an onium salt compound having in its structure a relatively large substituent group. Further, since the adsorption of ion onto the surface of powder would be minimized by steric hindrance, the benzene ring in the onium salt should preferably have an organic group having 1 to 20 carbon atoms. It is further preferable that not less than 50% of benzene ring is provided with 4 to 20 carbon atoms. If the benzene ring is regulated in this manner, the scattering of decomposed matters into air would be suppressed during the photo-reaction in addition to the improvement of dispersion stability, thereby making it possible to enhance the safety. Further, since these compounds are more excellent in solubility to a solvent, the phenomenon of the precipitation of salts in the photosensitive composition can be also suppressed.

When a monovalent onium salt is employed, the photosensitive wavelength thereof shifts toward the short wavelength side, thereby more likely causing the sensitivity thereof to degrade. However, when sulfur or oxygen, which are VI elements, is included in a heterocycle or an aromatic substituent group having sulfur or oxygen as a linking group therein is included in a chemical structure, the aforementioned problem can be overcome and hence such structures are preferable.

An onium salt comprising a relatively large organic group in its structure as shown in the following general formula (2) or (3) is advantageous in the respects that it is excellent in dissolution stability and dispersion stability.

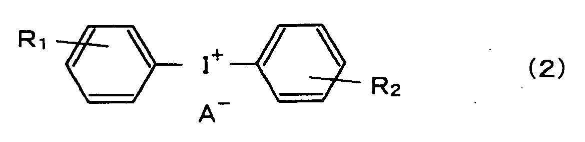

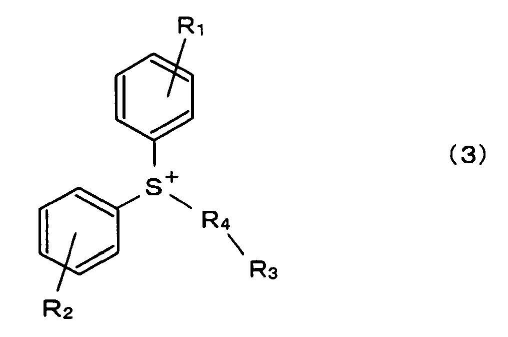

Herein, A⁻ is fluorophosphate anion; R₁, R₂ and R₃ may be the same or different and at least one of them is an organic group having 4 to 20 carbon atoms and the rest are an organic group having 1 to 20 carbon atoms and including hydrogen atom; and R₄ is a bivalent aromatic substituent group or a bivalent aromatic substituent group containing a VI atom therein.

As examples of the organic group to be introduced into R₁, R₂ and R₃, they include alkyl group having 4 to 20 carbon atoms such as propyl, butyl, hexyl, heptyl, octyl, nonyl, decanyl, etc.; alkyloxy group having 4 to 20 carbon atoms such as propyloxy, butyloxy, hexyloxy, heptyloxy, octyloxy, nonyloxy, decanyloxy, etc.; and a substituent group having 4 to 20 carbon atoms and polyethylene oxide skeleton where ethylene glycol is dehydrocondensed.

As examples of the bivalent aromatic substituent group to be introduced into R₄, they include a group having a phenylene skeleton such as phenylene and biphenylene; a group having a phenylene sulfide skeleton such as phenylene sulfide and phenylene disulfide; a group having a thiophene skeleton such as benzothiophenylene, thiophenylene and bithiophenylene; and a group having a furan skeleton such as furanylene and benzofuranylene.

The aforementioned onium salts are known to suppress the generation of harmful by-product such as benzene during the process of photo-reaction. When a dispersion containing these onium salts is employed as a photo-acid generating agent, it is possible to obtain a photosensitive composition which is provided with desirable properties in terms of environment and safety.

The content of the photo-acid generating agent in the photosensitive composition may be suitably determined based on the acid-generating efficiency of the photo-acid generating agent and on the quantity of powder component to be added. In this embodiment, the photo-acid generating agent is incorporated in the photosensitive composition, from the viewpoint of the sensitivity, at a content of 1 to 10% by weight in general, preferably 2 to 8% by weight, more preferably 2 to 6% by weight based on 100% by weight of the dispersion medium to be polymerized by the effect of acid included in the photosensitive composition. However, the employment of a sensitizing agent concurrent with the photo-acid generating agent is preferable, since it improves the dispersion stability of pigment and minimizes the corrosion of various members to be employed in the printing and also since it makes it possible to reduce the content of the photo-acid generating agent to the range of about 2 to 4% by weight.

As examples of the sensitizing agent, they include acridine compounds, benzofuravins, perylene, anthracene, thioxantone compounds and laser dyes. Among them, a compound formed of dihydroxyanthracene where hydrogen atom thereof is substituted by an organic group or thioxantone derivatives are expected to exhibit excellent effects. The content of the sensitizing agent may be generally 20 to 100% by weight, more preferably 30 to 60% by weight based on the photo-acid generating agent.

If the content of the photo-acid generating agent is less than 2% by weight based on 100% by weight of the solvent, the sensitivity of the photosensitive composition would be degraded. On the other hand, if the content of the photo-acid generating agent exceeds 10% by weight, the increase in viscosity with time of the ink would become prominent due to the deterioration of dispersion or to the dark reaction of dispersant, thus degrading not only the coating property of photosensitive composition but also the hardness of coated film after the photo-curing thereof. Furthermore, it may lead to the corrosion of the members of printing apparatus.

The aforementioned onium salts may be employed in combination with a nonpolar photo-acid generating agent which generates a relatively strong acid of different kind. In this case, the content of the onium salt can be reduced, thus making it possible to further suppress the flocculation with time of the powder. As examples of such a nonpolar photo-acid generating agent, they can be selected from the group consisting of sulfonyl compounds, sulfonate compounds, sulfamide compounds and organic halogen compounds. Among them, compounds which generate a strong acid such as fluoromethane sulfonic acid, hydrochloric acid or bromic acid are preferable for use as a photo-acid generating agent.

More specifically, it is possible to employ a sulfamide compound such as trifluoromethane sulfonamide of N-hydroxynaphthalimide, and organic halide compounds such as triazine halide compound. In the case where the content of these onium salts is confined to the range of 0.3 to 2% based on the weight of an acid-polymerizable solvent, the content of the nonpolar photo-acid generating agent may preferably be confined to the range of 2-10% based on the weight of the solvent.

Although it is required that the photosensitive composition according to this embodiment should preferably be high in stability of viscosity in order to keep the quality of cured product such as the quality of printed matter, it is sometimes impossible to keep the viscosity thereof over a long period, since the photosensitive composition generally tends to become higher in viscosity with time. In that case, it is preferable to incorporate, as a viscosity-stabilizing agent, at least either a basic compound or a compound capable of exhibiting basicity. The basic compound is also capable of exhibiting an effect to considerably suppress the corrosion of metallic members of printing apparatus that may be caused by an acid. Therefore, the incorporation of the basic compound is preferable in every formulations of the photosensitive composition according to this embodiment.

As the basic compound, although it is possible to employ any kind of inorganic base or organic base, provided that it is capable of dissolving in the aforementioned acid-polymerizable compounds, the employment of organic base is more preferable in view of solubility thereof. As examples of the organic base, they include, for example, ammonia or ammonium compound, substituted or unsubstituted alkyl amine, substituted or unsubstituted aromatic amine, pyridine, pyrimidine and an organic amine having a heterocyclic skeleton such as imidazole. More specifically, it is possible to employ n-hexylamine, dodecylamine, aniline, dimethylaniline, diphenylamine, triphenylamine, diazabicyclooctane, diazabicycloundecane, 3-phenyl pyridine, 4-phenyl pyridine, lutidine, 2,6-di-t-butyl pyridine, and sulfonylhydrazide such as 4-methylbenzene sulfonylhydrazide, 4,4'-oxybis(benzene sulfonylhydrazide) and 1,3-benzene disulfonylhydrazide.

Alternatively, an ammonium compound can be employed as the basic compound. For example, quaternary ammonium salt can be employed as a preferable example of the ammonium compound. For example, as the substituent group for ammonium moiety, it is possible to methyl, ethyl, propyl, isopropyl, butyl, dodecyl, phenyl, benzyl, etc. As the counter ion, anion such as hydroxide ion, ⁻OR (R is alkyl group having 1 to 4 carbon atoms), ⁻OCOR' (R' is alkyl, aryl or alkylaryl), OCOO⁻, and OSOO⁻ can be preferably employed. Especially preferable examples of the ammonium compound are tetramethyl ammonium hydroxide and tetrabutyl ammonium hydroxide. These basic compounds may be employed singly or in combination of two or more.

When a very strong basic compound such as imidazole is incorporated in the photosensitive composition, there are many possibilities that the polymerization with time may occur on the contrary or a side reaction such as the decomposition of photo-acid generating agent. On the other hand, when a compound which is too low in basicity is incorporated in the photosensitive composition, it may become difficult to sufficiently secure the effect of the stabilization of viscosity which is expected from the addition of a basic compound. For example, it is preferable to employ basic compounds exhibiting a base dissociation constant pKb of 4 or more at a temperature of 25°C and in a state of aqueous solution thereof. However, if the pKb of the basic compounds is higher than 11, such compounds would be incapable of exhibiting the effect of stabilizing the viscosity of photosensitive composition. Suitable examples of basic compounds which satisfy the aforementioned conditions are pyridine derivatives, aniline derivatives, aminonaphthalene derivatives, other nitrogen-containing heterocyclic compounds and the derivatives thereof.

Among these compounds, the employment of aniline derivatives as the basic compound is especially preferable in the respects of viscosity stability, volatility, basicity and the suppression of side reaction.

However, since the aniline compounds are relatively low basicity, the employment thereof in combination with an oxetane compound exhibiting basicity per se is not preferable in general. The oxetane compound should preferable be selected from those exhibiting such a high basicity that the pKb thereof at 25°C is confined within the range of 3 to 7. More specifically, basic compounds such as amine having an aliphatic skeleton or amine having an alicyclic skeleton can be suitably employed.

When the aforementioned basic compounds are capable of forming a salt with an anion and if the acidity of the anion is relatively low, the basic compounds will be enabled to exhibit a weak basicity, thereby enabling such basic compounds to be employed likewise.

The photosensitive composition according to the present invention may contain various powder to provide the photosensitive composition with various functions.

As for the kind of powder, there is not any particular limitation as long as the powder is capable of being dispersed in the aforementioned dispersion medium of photosensitive composition and capable of providing the photosensitive composition with functions desired. Examples of such a powder include powders having magnetic property, fluorescent property, conductive property, insulating property, dielectric property or electromagnetic exothermic property. It is also possible to employ powders which are capable of enhancing the heat resistance or mechanical strength of the cured product. More specifically, it is possible to employ metals, metal oxides, metal nitrides, metal carbides, metal carbonate, metal sulfide, inorganic or organic fluorescence, carbon fiber, etc.

As the powder which provides the photosensitive composition with electric conductivity, metals are generally employed. For example, it is possible to employ gold, silver, copper, platinum, palladium, nickel, indium, titanium, antimony, tin, rhodium, ruthenium, or an alloy of these metals. It is also possible to employ oxides of these metals, thereby enabling to create an ITO film or to subsequently convert them into metal films through the reduction treatment thereof after the coating of them or the irradiation of light to them.

It is also possible to use, other than metals, conductive carbon powder or carbon fiber.

As the powder exhibiting fluorescence, it is possible to employ not only inorganic fluorescence materials but also organic fluorescence materials. As the inorganic fluorescence materials, examples of which include MgWO₄, CaWO₄, (Ca,Zn)(PO₄)₂:Ti⁺, Ba₂P₂O₇:Ti, BaSi₂O₅:Pb²⁺, Sr₂P₂O₇:Sn²⁺, SrFB₂O_{3.5}:Eu²⁺, MgAl₁₆O₂₇:Eu²⁺, and inorganic acid salts such as tungstenate and sulfate. As the organic fluorescence materials, examples of which include acridine orange, amino acridine, quinacrine, anilinonaphthalene sulfonate derivatives, anthroyl oxystearic acid, auramine O, chlorotetracycline, cyanine dye such as merocyaninen and 1,1'-dihexyl-2,2'-oxacarbocyanine, dansyl sulfonamide, dansyl choline, dansyl galactoside, dansyl tolidine, dansyl chloride derivatives such as dansyl chloride, diphenyl hexatriene, eosin, ε-adenosine, ethidium bromide, fluorescein, foamycine, 4-benzoylamide-4'-aminostilbene-2,2'-sulfonic acid, β-naphthyl triphosphic acid, oxonol dye, parinaric acid derivatives, perylene, N-phenylnaphthyl amine, pyrene, safranine O, fluorescamine, fluorescein isocyanate, 7-chloronitrobenzo-2-oxa-1,3-diazole, dansylaziridine, 5-(iodoacetamide ethyl) aminonaphthalene-1-sulfonic acid, 5-iodoacetamidefluorescein, N-(1-anilinonaphthyl 4) maleimide, N-(7-dimethyl-4-methylcumanyl) maleimide, N-(3-pyrene) maleimide, eosin-5-iodoacetamide, fluorescein mercury acetate, 2-[4'-(2"-iodoacetamide)]aminonaphthalene-6-sulfonic acid, Rhodamine derivatives, organic EL dye, organic EL polymer, organic EL crystal and dendrimer.

As the powder which is capable of enhancing the insulation of cured product, it is possible to employ, for example, insulating ceramic powder that can be contained in a green sheet, crystallized glass powder, and other kinds of insulating powder.

As the powder which is capable of enhancing the heat resistance and physical strength of cured product, it is possible to employ, for example, various fillers such as the oxides or nitrides of aluminum or silicon, silicon carbide, talc, mica, etc. Further, iron oxide powder and ferromagnetic powder are suited for providing magnetism to the cured product. Metal oxide powder which is high in dielectric constant such as tantalum oxide powder and titanium oxide powder can be incorporated in the photosensitive composition.

Aforementioned various kinds of powders can be employed singly or in combination of two or more.

Although there is not any particular limitation with respect to the content of these powders, these powders should be incorporated as much as possible, for example, within the range of 50 to 98% by weight, when these powders are to be employed for providing electric conductivity to the cured product.

There is not any particular limitation with respect to the particle diameter of these powders, provided that the particle diameter is such that makes it possible to form a desired film thickness. Namely, an optimum particle diameter of these powders can be optionally selected depending on the printing method employed. For example, if screen printing is to be employed, the particle diameter of these powders should preferably be confined to the range of 100 nm to 10 µm or so. When the printing is performed by inkjet printing, the particle size of these powders should be as small as possible. In order to enable the photosensitive composition to be stably delivered from the inkjet nozzle, the particle diameter of these powders should preferably be confined to 300 nm or less. The viscosity of the ink comprising such powder should be 50 mPa·s or less at a temperature 25°C.

In order to enable the powder to disperse uniformly in the dispersion medium, it would be effective to coat the powder with a dispersing agent. This coating treatment is generally performed by a resinous dispersing agent. It is possible to enable the resinous dispersing agent to enter into the interface between the pigment particles and the organic dispersant, thereby preventing the pigment particles from being flocculated. This resinous dispersing agent also acts to enhance the affinity of pigment particles to the dispersion medium, thus preventing the pigment particles from settling. Basically, any kind of resin which is excellent in affinity to the dispersant and provided with a steric separating power for preventing the flocculation among the pigments can be employed as a resinous dispersing agent. For example, it is possible to employ, as a dispersing agent, a resin composition containing, as a major component, at least one selected from the group consisting of vinyl polymer or copolymer, acrylic polymer or copolymer, polyester, polyamide, polyimide, polyurethane, amino polymer, silicon-containing polymer, sulfur-containing polymer, fluorine-containing polymer and epoxy resin.

In order to enable the dispersing agent to act effectively, the terminal of the aforementioned polymers should preferably be excellent in bonding property and in affinity to the powder particles. On the other hand, the main chain of the polymers should preferably be excellent in affinity to the dispersion medium and provided with a physical repulsive force or electrostatic repulsive force for preventing the reflocculation with other powder particles. For example, the aforementioned polymers should preferably have a solubility parameter (about ±5 MPa^{1/2}) which is equivalent to that of the dispersion medium, a molecular weight ranging from several hundreds to several tens of thousands, a polymerization degree ranging from about 10 to 200 and a Tg ranging from 10°C to 200°C. Further, the aforementioned polymers should preferably have a terminal which is relatively high in chemical bond (covalent bond, electrostatic force, etc.), thereby providing it with affinity to the powder particles. When the aforementioned polymers are respectively composed of a copolymer comprising two or more monomers, it is generally possible to provide the aforementioned polymers with the aforementioned composite functions. As such polymers, a block copolymer can be also preferably employed.

Although the aforementioned terminal of polymer may not necessarily be limited to only one, it can be generally introduced into an end portion of a graft copolymer or an end portion of tandem polymer. The polymer thus obtained is not only strong in bonding but also readily capable of forming a steric hindrance which is effective in suppressing the reflocculation among pigment particles.

As the monomer for synthesizing such a polymer, it is possible to employ styrene and substituted styrene, (meta)acrylate, (meta)acrylic acid, (meta)acrylic amide, maleic acid, maleic anhydride, maleate, itaconic acid and esters thereof, hydroxystyrene and hydrogen-substituted derivatives thereof, etc. Further, monomers comprising an ester side chain having long chain alkyl, polyether, polycarbonate, polyester chain, etc. are advantageous in creating the aforementioned tandem polymer.

As the aforementioned polymer, it is possible to employ the following compounds. They include, for example, polyester compounds to be obtained through a dehydrating condensation between a dihydroxy compound such as poly(oxyphthaloyloxymethylene-1,4-phenylenemethylene) and poly(1,4-cyclohexylene dimethylene succinate) and dicarboxylic acid; polyamide to be obtained through a condensation among adipic acid, diamine such as hexamethylene diamine, and dicarboxylic acid; polyamide to be obtained through the ring opening of cyclic lactone such as ε-caprolactam; a kind of polyamide which is relatively low in Tg and which can be obtained through a condensation between tetracarboxylic acid such as pyromellitic acid and aliphatic diamine; polyurethane resin to be obtained from a reaction between aliphatic diisocyanate such as isophorone dicyanate and dihydroxy compound; polyvinyl pyridine compound; polydimethyl siloxane and a ladder type polymer thereof; polyvinyl alcohol and vinyl ether compound; and polyether polymer to be obtained through the polymerization of an oxirane compound having a relatively rigid skeleton. The terminal of these polymers may be capped with a compound having a functional group excellent in affinity to the pigment. As examples of such a functional group, they include amino group, phosphoric group, etc.

Further, a polymer compound to be obtained through the polymerization between an amphipathic polymerizable surfactant having a polymerizable group and a crosslinking monomer and/or monofunctional monomer can be also preferably employed as the resinous dispersing agent. As the polymerizable group of the polymerizable surfactant, it is possible to preferably employ an unsaturated hydrocarbon group such as vinyl group, allyl group, acryloyl group, methacryloyl group, propenyl group, vinylidene group and vinylene group. These groups can be employed singly or in combination of two or more. As the hydrophilic group of the polymerizable surfactant, it can be selected depending on the dispersion medium. When the dispersion medium is aqueous, at least one selected from sulfone group, sulfonic acid group, carboxyl group, carbonyl group, hydroxyl group and salts thereof can be preferably employed. On the other hand, when the dispersion medium is oily, it is possible to employ carboxyl group and esters thereof, lactone compound, carbonyl group and hydroxyl group.

When the powder is formed of metals, a compound which is capable of effecting a coordinate bond with a metal element can be employed as a dispersing agent (dispersant) in addition to the aforementioned dispersing agents. Examples of such a compound are amine, alcohol, phenol and thiol compounds. More specifically, it is possible to employ 2-methylamino ethanol, diethanol amine, diethylmethyl amine, 2-dimethylamino ethanol, methyldiethanol amine, ethylene diamine, alkyl amine, ethylene glycol, propylene glycol, alkyl thiol, ethane dithiol, and alkyl alcohol. It is also possible to employ protein such as MrgA protein, DpsA protein, modified protein wherein amino acid sequence of these proteins is modified, and virus such as adenovirus, rotavirus, poliovirus and modified virus thereof.

In order to adjust the surface tension, etc., a small quantity of low molecular additives such as a nonionic surfactant, an inonic surfactant, an electrifying agent may be added to the photosensitive composition of this embodiment. When a cationic additive is employed as a low molecular additive, it is preferable to select it from the compounds which are lower in acidicity than carboxylic acids. Because, some of the cationic additives may promote the dark curing reaction of the photosensitive composition. Further, a low molecular additive having a strong basicity and pigment may not only degrade the sensitivity of photosensitive reaction but also promote the dark curing reaction likewise. In order to prevent such problems, it is preferable to employ a low molecular additive which is nearly neutral or a nonionic surfactant.

The composite members or electronic parts according to the embodiment can be manufactured by printing the photosensitive composition of the embodiment on a substrate. As the printing method, it is possible to employ, for example, screen printing, off-set printing, inkjet printing, and pad printing. When the printed layer is exposed to light after the printing, an acid is generated from a cationic photopolymerization initiator. This acid acts as an initiator for the chain reaction of polymerizable compound or as a catalyst in the cross-linking reaction, thereby enabling the photosensitive composition to cure.

The acid generated from the irradiation of light disperses into the printed film and acts as a catalyst. The dispersion of the acid as well as the cross-linking reaction wherein the acid is acting as a catalyst can be accelerated by heating. In contrast to the radical polymerization, the cross-linking reaction to be generated in this case cannot be obstructed by the presence of oxygen. Therefore, it is possible to generate a plurality of cross-linking reactions using only one photon, enabling to obtain high sensitivities. Moreover, since the cross-linking reaction where an acid is acting as a catalyst proceeds rapidly even inside a deep portion of the printed layer or inside the absorptive substrate, the printed layer is also very excellent in adhesion as compared with that to be obtained from the radical polymerization.

Therefore, when the printed layer is irradiated with light or slightly heated subsequent to the formation thereof through the printing of photosensitive composition on a printing surface, the printed layer can be quickly non-fluidized. Namely, it is possible, through the employment of the photosensitive composition according to the embodiment, to obtain a printed layer or film of high quality without necessitating the employment of a large scale exposure system.

The composite members according to the embodiment comprise a resin portion and a metal portion, wherein the resin portion is constituted by a cured product of the photosensitive composition according to the embodiment. These resin portion and metal portion can be laminated on a substrate for instance. The resin portion can be obtained through a process wherein the photosensitive composition according to the embodiment is printed at first and then optically cured. The metal portion can be formed by deposition, plating and etching. Alternatively, a metal plate may be employed as a substrate. In this case, since the peeling of a laminated portion may occur unless the adhesion of the laminated portion to metal is sufficiently strong, the photosensitive composition is required to have a sufficient adhesivity to metal. The composite member constituted by such a laminate structure can be employed for the manufacture of electronic parts such as a circuit board, a display panel, etc., recording media such as DVD, etc.

If the composite member is to be employed for the manufacture of electronic parts such as a circuit board, a display panel, at least one of the insulating portion and the conductive portion constituting the composite member can be fabricated from the cured product of the photosensitive composition according to the embodiment. The photosensitive composition according to the embodiment is capable of providing either insulating or conductive property. It is possible, through a process comprising the printing of the photosensitive composition, the optical curing thereof and the lamination thereof, to fabricate a laminated structure consisting of an insulating layer and a conductive layer. More specifically, using an insulating photosensitive composition wherein the aforementioned insulating powder is dispersed and a conductive photosensitive composition wherein conductive powder is dispersed, it is possible to fabricate a laminated structure consisting of an insulating layer and a conductive layer.

Although there is not any particular limitation with regard to the method of lamination, it is possible to employ a printing method such as screen printing and inkjet printing. Especially, the inkjet printing is convenient since various articles can be manufactured on demand. As for the number of lamination, there is not any particular limitation. In the case where the printing is performed by inkjet, the photosensitive composition is required to be fluid at ordinary temperature. More specifically, the viscosity thereof at a temperature 25°C should be 50 mPa·s or less, more preferably 30 mPa·s or less. Further, in the case where the head of inkjet is made adjustable in temperature, the viscosity of ink at the adjusted temperature of the head should preferably be confined to the range of 5 to 20 mPa·s.

The photosensitive composition according to the embodiment is negative in the AMES test and hence safe and is moreover excellent in adhesion to metals as well as to a resin substrate. Especially, the photosensitive composition can be cured by UV irradiation, thus enabling the photosensitive composition to be suitably employed for the manufacture of a composite member and electronic parts.

Next, examples of the present invention and comparative examples will be explained as follows.

The photosensitive compositions of Examples 1-10 were prepared according to the formulations shown in the following Table 1.

**Table 1**

| Components | Examples | | | | | | | | | |
|---|---|---|---|---|---|---|---|---|---|---|
| | 1 | 2 | 3 | 4 | 5 | 6 | 7 | 8 | 9 | 10 |
| C3000 | 10 | 10 | 10 | 10 | 10 | 10 | 10 | 5 | 10 | 10 |
| OXT221 | | | | | | 5 | 20 | 20 | 20 | 30 |
| OXT211 | 40 | 40 | 40 | 40 | 40 | 35 | 30 | 40 | 35 | 30 |
| ONB-DVE | 50 | 50 | 50 | 50 | 50 | 50 | 40 | 35 | 35 | |
| ISB-DVE | | | | | | | | | | 30 |
| UVACURE1590 | 8 | 8 | 8 | 8 | 8 | 8 | 8 | 8 | 8 | 8 |
| Dibutoxy anthracence | 30 | 30 | 30 | 30 | 30 | 30 | 30 | 30 | 30 | 30 |
| Medium | SUS | Copper | Aluminum | PET | PP | SUS | SUS | SUS | SUS | SUS |

The components shown Table 1 represent the following compounds.
C3000: Celloxide 3000 (limonene dioxide: Daicel Chemical Industries Ltd.)
OXT-221 (di[1-ethyl(3-oxetanyl)]methyl ether)
OXT-211 (3-ethyl-3-(phenoxymethyl) oxetane)
(These oxetane compounds are all manufactured by Toagosei Co., Ltd.)
ONB-DVE (hydroxymethyl-hydroxyoxanorbornanediol divinyl ether)
ISB-DVE (isosorbide divinylether)
(These vinyl ether compounds are all manufactured by Daicel Chemical Industries Ltd.)
Polymerization initiator: Uvacure 1590 (Daicel UCB)
Sensitizer: dibutoxy anthracene (Kawasaki Kasei Co., Ltd.)

The values shown in Table 1 all represent wt% based on the weight of dispersion medium. However, the values representing the weight of polymerization initiator all represent wt% based on the weight of a total of dispersion mediums and the values representing the weight of sensitizer all represent wt% based on the weight of polymerization initiator.

Among these compounds, ONB-DVE and ISB-DVE are all vinyl ether compounds represented by the aforementioned general formula (1). C3000 and OXT-211 are respectively a monofunctional compound.

Further, the photosensitive compositions of Comparative Examples 1-5 were prepared according to the formulations shown in the following Table 2.

**Table 2**

| Components | Comparative Examples | | | | |
|---|---|---|---|---|---|
| | 1 | 2 | 3 | 4 | 5 |
| C3000 | 20 | 10 | | 40 | 20 |
| OXT221 | | 90 | 50 | | 70 |
| OXT211 | | | | 40 | |
| ONB-DVE | 80 | | 50 | 20 | 10 |
| ISB-DVE | | | | | |
| UVACURE1590 | 8 | 8 | 8 | 8 | 8 |
| Dibutoxy anthracence | 30 | 30 | 30 | 30 | 30 |
| Medium | SUS | SUS | SUS | SUS | SUS |

The composition of Comparative Example 1 contained no oxetane compound, and the composition of Comparative Example 2 contained no vinyl ether compound. Further, the composition of Comparative Example 3 contained no monofunctional compound, and the composition of Comparative Example 4 contained the monofunctional compound at a content of more than 70 wt% based on a total weight of the solvent. The composition of Comparative Example 5 contained the vinyl ether compound at a content of less than 30 wt% based on a total weight of the solvent.

Using the photosensitive compositions prepared in Examples 1-10 and in Comparative Examples 1-5 as described above, cured products were formed on predetermined substrates. As the substrates, a SUS plate, a copper plate, an aluminum plate, a PP film and a PET film were prepared. These photosensitive compositions were respectively coated on these substrates by a bar coater to form coated films each having a film thickness of about 10 µm. To these coated films thus formed, light was irradiated at an integrated dosage of 140 mJ/cm² by Light Hammer 6 (Fusion Co., Ltd.).

These coated films thus irradiated were then heated for 5 minutes at a temperature of 120°C to form cured products. Incidentally, with respect to the PP film and PET film, the heating was performed for 5 minutes at a temperature of 100°C. The cured products thus obtained were investigated with respect to the cured hardness, solvent resistance and adhesion.

The cured hardness was assessed based on the pencil hardness test (JIS K5600-5-4; ISO/DIS 15184). In the assessment of the solvent resistance, the surface of the cured product was rubbed with a swab impregnated with ethanol to measure the number of repetition of rubbing which was required to peel the cured product. The sample which required 100 times or more of the repetition of rubbing was marked by the symbol of "B", the sample which required 300 times or more of the repetition of rubbing was marked by the symbol of "A", and the sample which required less than 100 times of the repetition of rubbing was marked by the symbol of "C".

The adhesion was assessed based on the cross-cut peel test (JIS K5600-5-6; ISO 2409). In Tables 3 and 4, the classification of adhesion based on JIS K5600-5-6 are shown. Incidentally, the adhesion of cured products was investigated twice, i.e. immediately after the curing and 10 days later.

Further, using salmonella (TA100, TA1535, TA98 and TA1537 strains) and colibacillus (WP2 uvrA strain), the AMES test was performed. The sample indicated negative was marked by the symbol of "○" and the sample indicated positive was marked by the symbol of "×".

The results obtained are summarized in the following Tables 3 and 4.

**Table 3**

| | Examples | | | | | | | | | |
|---|---|---|---|---|---|---|---|---|---|---|
| | 1 | 2 | 3 | 4 | 5 | 6 | 7 | 8 | 9 | 10 |
| Pencil hardness | 3H | 4H | 2H | H | H | 3H | 3H | 2H | 3H | H |
| Ethanol resistance | B | B | B | B | B | A | A | B | B | B |
| Adhesion | 0 | 0 | 0 | 0 | 0 | 0 | 5 | 0 | 0 | 0 |
| Adhesion after 10 days | 0 | 0 | 0 | 0 | 0 | 0 | 0 | 0 | 0 | 0 |
| AMES test | ○ | ○ | ○ | ○ | ○ | ○ | ○ | ○ | ○ | ○ |

**Table 4**

| | Comparative Examples | | | | |
|---|---|---|---|---|---|
| | 1 | 2 | 3 | 4 | 5 |
| Pencil hardness | HB | B | H | HB | B |
| Ethanol resistance | C | C | A | C | A |
| Adhesion | 5 | 3 | 5 | 0 | 5 |
| Adhesion after 10 days | 5 | 1 | 5 | 0 | 5 |
| AMES test | × | ○ | ○ | × | × |

As shown in above Table 3, the photosensitive compositions of Examples 1-7 where an oxetane compound such as OXT-221 or OXT-211 and a vinyl ether compound, i.e. ONB-DVE, were included therein as dispersion mediums were all found excellent in cured hardness, solvent resistance and adhesion. With respect to the adhesion, excellent results were obtained not only with respect to metal substrates formed of stainless steel (SUS), copper, aluminum, etc., but also with respect to resin substrates formed of PP, PET, etc.

Further, the photosensitive composition of Example 8 where ISB-DVE was included therein as a vinyl ether compound was also found capable of forming a cured product which was excellent in cured hardness, solvent resistance and adhesion.

Moreover, the photosensitive compositions of Examples 1-10 all indicated negativity in the AMES test and were confirmed safe.

Incidentally, the photosensitive compositions where OXT-221 was contained therein as a portion of solvent were very excellent in solvent resistance to acetone.

Example 7 indicated that the development of adhesion to metals could be delayed deliberately. This is advantageous in that it is possible to alleviate the stress on the occasion of cure shrinkage and to improve the releasability from a mold.

Whereas, the photosensitive compositions of Comparative Examples were found incapable of meeting all of conditions including cured hardness, solvent resistance, adhesion, and the negativity in the AMES test. Specifically, in the case of Comparative Example 1 where an oxetane compound was not included therein, solvent resistance and adhesion were found insufficient and the result of AMES test was positive even though cured hardness was found excellent. In the case of Comparative Example 2 where a vinyl ether compound was not included therein, cured hardness, solvent resistance, and adhesion were found insufficient and only the AMES test was satisfied, i.e. negative. In the case of Comparative Example 3 where a monofunctional compound was not included therein, although cured hardness and solvent resistance were found sufficient but adhesion was found insufficient. In the case of Comparative Example 4 where a monofunctional compound was included excessively therein, although cured hardness and adhesion were found sufficient but solvent resistance was found insufficient and the result of AMES test was positive. In the case of Comparative Example 5 where the content of a vinyl ether compound was too small, only solvent resistance was found sufficient but cured hardness and adhesion were found insufficient and furthermore, the result of AMES test was positive.

### (Example 11)

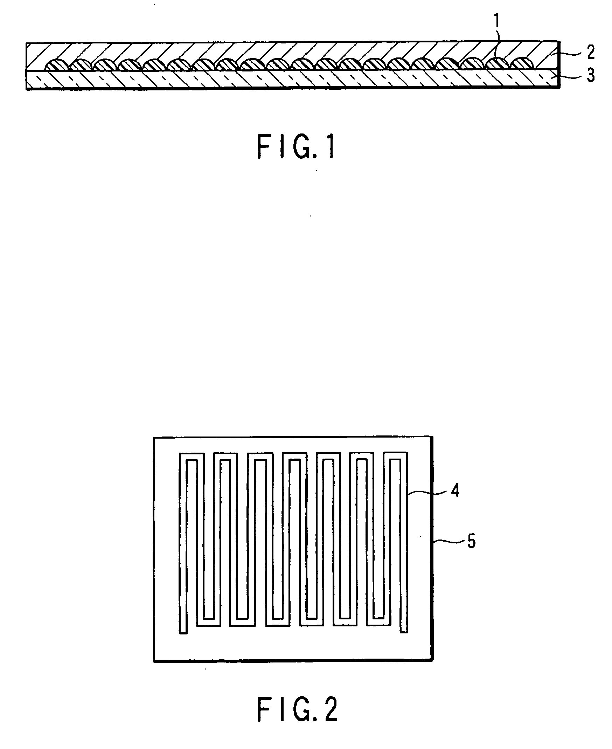

Using a photosensitive composition prepared so as to have the same composition as that of aforementioned Example 5, a microlens array was prepared on a polymethyl methacrylate (PMMA) transparent substrate. In the preparation of the microlens array, a mold having recesses corresponding to the configuration of the microlens array was prepared and the fluid photosensitive composition was coated over the recesses to form a coated film. Then, a PMMA transparent substrate was adhered onto the coated film. Subsequently, ultraviolet rays were irradiated from the PMMA transparent substrate side to cure the photosensitive composition. The state of coated film thus cured is shown in FIG. 1. As shown in FIG. 1, a mold 2 was placed on a PMMA transparent substrate 3 and a microlens 1 was formed from the photosensitive composition which was cured in the recesses of the mold 2.

Finally, the mold 2 was peeled off to obtain the microlens array. In this case, the releasability of the microlens array from the mold was excellent.

### (Example 12)

Spherical silver powder (CuLox 0010, CuLox Co., Ltd.) was mixed with the photosensitive composition of Example 1 at a weight ratio of 70/30 to prepare a mixture, to which 1 wt% of a dispersant (Disparon 1860, Kusumoto Kasei Co., Ltd.) was added. Further, the resultant mixture was subjected to a dispersion treatment for 30 minutes by rocking mill to obtain a conductive photosensitive composition (conductive paste).

The conductive paste thus obtained was coated on a vinyl chloride substrate by screen printing to form a paste pattern having a line width of 1 mm and a length of 1 m. In this coating, a 180 mesh screen plate 50 µm in emulsion thickness was employed. After the paste pattern was irradiated with ultraviolet rays, the paste pattern was heated at a temperature of 150°C for 30 minutes to obtain a conductive pattern. The state of the conductive pattern is shown in FIG. 2. As shown in FIG. 2, the conductive pattern 4 was formed on a substrate 5.

The surface resistance between terminals of the conductive pattern 4 was not more than 0.1 Ω/□, thus confirming the conductivity thereof. Further, this pattern 4 was found excellent in adhesion to the vinyl chloride substrate which was employed as the substrate 5.

### (Example 13)

By the method shown in Thin Solid Films, 327(1998), 524-527, silver nanoparticles were prepared. The silver nanoparticles thus obtained were found to have an average particle diameter of 5 nm and the surfaces of the silver nanoparticles were coordinated with C₁₇H₃₅CO₂ group, thus enabling the silver nanoparticles to disperse. The silver nanoparticles were formulated as a toluene dispersion.

Further, a composition comprising only the dispersion medium included in the composition of Example 1 was prepared.

The toluene solution of the silver nanoparticles was mixed with the composition of the dispersion medium at a weight ratio of 70/30 to obtain a mixture, which was then treated using a rotary evaporator to evaporate and remove only the toluene. Further, by following the same procedure to prepare the composition shown in Example 1, the polymerization initiator and the sensitizer were added to the mixture to prepare a silver nanoink for inkjet.

Using this ink, a conductive pattern having a line width of 50 µm was printed on a polyimide sheet by an inkjet head (Toshiba TEC Co., Ltd.). After this conductive pattern was irradiated with ultraviolet rays, the conductive pattern was heated at a temperature of 200°C for 60 minutes to obtain a cured conductive pattern.

The surface resistance between terminals of the conductive pattern thus obtained was 0.1 Ω/□ or less, thus confirming the conductivity thereof. Further, this pattern was found excellent in adhesion to the polyimide sheet which was employed as a substrate.

### (Example 14)

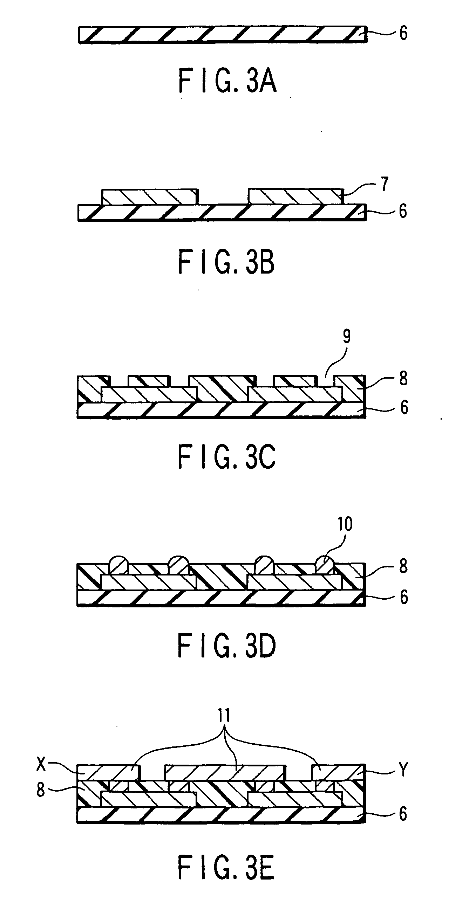

Using the ink prepared in Example 13, a multi-layer wiring board was prepared. This example will be explained with reference to FIGS. 3A to 3E.

First of all, as shown in FIG. 3A, a glass/epoxy substrate was prepared as an insulating substrate 6.

The ink was coated on the insulating substrate 6 by inkjet printing method in the same manner as employed in Example 13 to form a conductive pattern 7 as shown in FIG. 3B. More specifically, the conductive ink was coated on the substrate using the inkjet head and, after being irradiated with ultraviolet rays, the coated film was heated for 60 minutes at a temperature of 200°C.

Then, an insulating ink (Electrodag 452SS, Moritechs Co., Ltd.) was coated over the aforementioned conductive pattern 7 by screen printing and the layer thus coated was heated for 30 minutes at a temperature of 120°C to form an insulating layer 8. Incidentally, this insulating layer 8 may be formed by inkjet printing. In that case, the inkjet printing will be conducted twice and the planarizing treatment of the surface may be performed. Subsequently, through-holes 9 were formed in the insulating layer 8 as shown in FIG. 3C.

In these through-holes 9, a conductive layer 10 was deposited as shown in FIG. 3D. The deposition of the conductive layer 10 was performed as follows. Namely, a conductive ink was introduced into the through-holes 9 by inkjet printing at first and then irradiated with ultraviolet rays. Thereafter, the conductive ink was heated for 60 minutes at a temperature of 250°C.

A conductive ink was printed on the insulating layer 8 by inkjet printing method and then, subjected to the irradiation of ultraviolet rays and heating to form an electrode layer constituted by a conductive pattern 11 as shown in FIG. 3E.

When a conductivity test was performed between the opposite electrodes (x) and (y) of the opposite ends of the multi-layer wiring board thus manufactured, it was possible to confirm the electric conductivity therebetween.

### (Example 15)

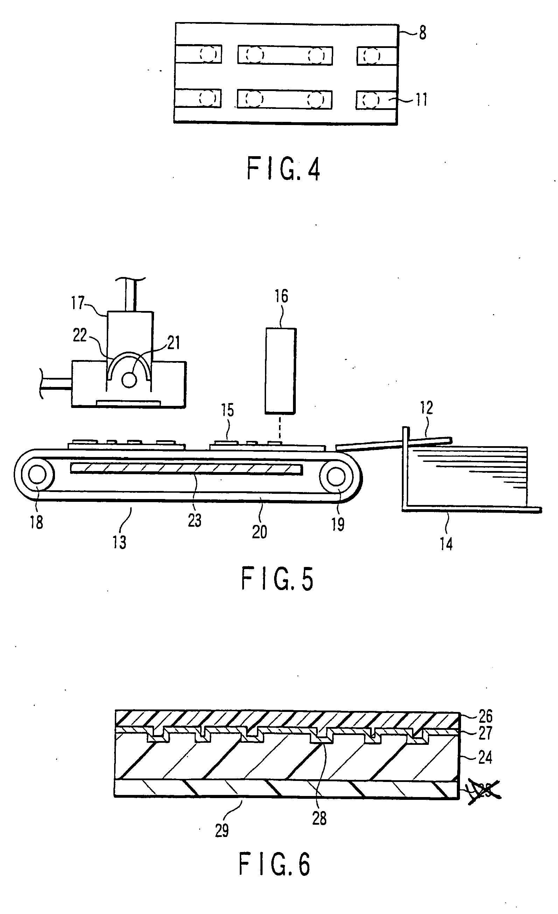

Using the conductive paste prepared in Example 12, a multi-layer wiring board was prepared. This example will be explained with reference to FIGS. 3 and 4.

First of all, as shown in FIG. 3B, a conductive pattern 7 was formed by repeating the same procedure as explained in Example 14. Then, by screen printing, an insulating ink was coated so as to superimpose it on this conductive pattern 7. The insulating ink employed herein was the same as that of the photosensitive composition shown in Example 1. After the printing of the insulating ink, the insulating ink was irradiated with ultraviolet rays and then heated for 30 minutes at a temperature of 120°C to form an insulating layer 8. Subsequently, through-holes 9 were formed in the insulating layer 8 as shown in FIG. 3C.

Thereafter, in the same manner as in Example 14, a conductive layer 10 was deposited in these through-holes 9 as shown in FIG. 3D. The deposition of the conductive layer 10 was performed as follows. Namely, a conductive ink was introduced into the through-holes 9 by inkjet printing at first and then irradiated with ultraviolet rays. Thereafter, the conductive ink was heated for 60 minutes at a temperature of 250°C.

A conductive ink was printed on the insulating layer 8 by inkjet printing method and then subjected to the irradiation of ultraviolet rays and heating to form an electrode layer constituted by a conductive pattern 11 as shown in FIG. 3E. The plan view of the multi-layer wiring board thus manufactured is shown in FIG. 4. As shown in FIG. 4, the conductive pattern 11 was formed in two rows on the insulating layer 8.

When a conductivity test was performed between the opposite electrodes (x) and (y) of the opposite ends of the multi-layer wiring board thus manufactured, it was possible to confirm the electric conductivity therebetween. Further, with respect to the insulation between two rows of conductive pattern, the surface resistance thereof was confirmed as being 1 × 10¹¹ Ω/□ or more.

### (Example 16)

Barium ferrite magnetic powder having an average particle diameter of 0.7 µm was mixed with the photosensitive composition of Example 1 at a weight ratio of 40/60 to prepare a mixture, to which 5 wt%, based on the magnetic powder, of a dispersant (Eslex A, Sumitomo Kagaku Co., Ltd.) was added. Further, the resultant mixture was subjected to a dispersion treatment for 30 minutes by sand mill to obtain a magnetic ink.

The magnetic ink thus obtained was coated on a PET substrate by screen printing to form a coated film of barcode pattern having a width of 10 mm and a length of 5 cm. In this coating, a 180 mesh screen plate 15 µm in thickness was employed. After the barcode pattern was irradiated with ultraviolet rays, the barcode pattern was heated at a temperature of 120°C for 5 minutes. Then, the coated film of barcode pattern was magnetized between N-N faced magnets, thus obtaining a magnetic recording layer.

When the magnetic output was detected by contacting this magnetic recording layer with a magnetic sensor, it was possible to identify the barcode. Further, the barcode thus obtained was found excellent in adhesion to the PET substrate.

### (Example 17)

Barium ferrite magnetic powder having an average particle diameter of 0.1 µm was mixed with the photosensitive composition of Example 1 at a weight ratio of 40/60 to prepare a mixture, to which 5 wt%, based on the magnetic powder, of a dispersant (Eslex A, Sumitomo Kagaku Co., Ltd.) was added. Further, the resultant mixture was subjected to a dispersion treatment for 30 minutes by sand mill to obtain a magnetic ink.

The magnetic ink thus obtained was coated on a PET substrate by inkjet printing to form a coated film of barcode pattern having a width of 10 mm and a length of 5 cm. The film thickness of the coated film was 10 µm. In this coating, a printing apparatus provided with an inkjet head (Toshiba TEC Co., Ltd.) was employed. The construction of this printing apparatus is schematically shown in FIG. 5.

As shown in FIG. 5, the substrate 12 is delivered from a substrate supply portion 14 to a substrate transferring portion 13. The substrate transferring portion 13 is constituted by a driving roller 18, a follower roller 19, and a transferring belt 20. A permanent magnet 23 is disposed below the transferring belt 20.

The ink was delivered to the substrate 12 from an inkjet head 16 to form a coated film of barcode pattern. This barcode pattern was then subjected to magnetization and orientation treatments prior to the curing thereof.

After the orientation treatment, the coated film of barcode pattern was irradiated with ultraviolet ray by an ultraviolet ray irradiation apparatus 17. Subsequently, the coated film of barcode pattern was heated for 5 minutes at a temperature of 120°C by a bulb 21 equipped with a reflection plate 22 to a magnetic recording layer 15.

When the magnetic output was detected by contacting this magnetic recording layer 15 with a magnetic sensor, it was possible to identify the barcode. Further, the barcode thus obtained was found excellent in adhesion to the PET substrate.

### (Example 18)

This example will be explained with reference to FIG. 6.

First of all, a recording layer 28 formed from an aluminum deposition layer 27 was disposed on a polycarbonate substrate 24, thus preparing an optical disc 29. On this aluminum deposition layer 27 was coated the photosensitive composition shown in Example 7 by spin coating so as to form a coated film having a thickness of 5 µm.

The coated film thus obtained was irradiated with ultraviolet rays and then heated for 10 minutes at a temperature of 120°C to cure the coated film, thus obtaining a protective film 26.

The protective film 26 of the optical disc thus formed was found 3H in pencil hardness, indicating a sufficient hardness. The adhesion of the protective film 26 one day later after the curing thereof was excellent and the warpage or deformation thereof due to the cure shrinkage was not recognized at all.

According to one aspect of the present invention, it is possible to provide a photosensitive composition which is negative in the AMES test and hence excellent in safety, is excellent in adhesion to a metal substrate or a resin substrate, and is especially suited for the use involving the application of UV curing. According to the present invention, there are further provided composite members and electronic parts where such a photosensitive composition is employed.

## Claims

1. A photosensitive composition, comprising
a cationic photopolymerization initiator; and
an organic dispersion medium containing at least one kind of oxetane compound, at least one kind of vinyl ether compound represented by the following general formula (1), and an oxirane compound, at least one of the oxetane, vinyl ether and oxirane compounds being a monofunctional compound, wherein the monofunctional oxetane compound is an oxetane compound containing one oxetane ring, the monofunctional vinyl ether compound is a vinyl ether compound containing one vinyl ether group, and the monofunctional oxirane compound is an oxirane compound containing one oxirane ring,
R¹¹-R¹²-(R¹¹)ₚ (1)
wherein R¹¹ s are individually a group selected from the group consisting of a vinyl ether group, a vinyl ether skeleton-bearing group, an alkoxy group, a substituted hydroxyl group and a hydroxyl group, at least one of R¹¹s being a vinyl ether group or a vinyl ether skeleton-bearing group; R¹² is a (p+1)-valent group having a substituted or unsubstituted cyclic ether skeleton; and p is a positive integer including zero, and
wherein the monofunctional compound is contained in the organic dispersion medium at a content of 20% or more and 70% or less based on the total weight of the organic dispersion medium, the vinyl ether compound is contained in the organic dispersion medium at a content of not less than 30% by weight based on the total weight of the organic dispersion medium, the oxetane compound is contained in the organic dispersion medium at a content of 20% or more and 60% or less based on the total weight of the organic dispersion medium, and the oxirane compound is contained in the organic dispersion medium at a content of not more than 30% based on the total weight of the organic dispersion medium.

2. The photosensitive composition according to claim 1, **characterized in that** the vinyl ether compound is one of the compounds represented by the following chemical formulas:

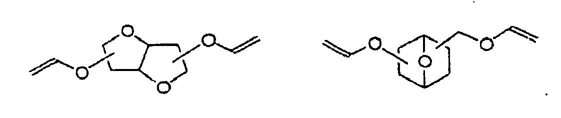

3. The photosensitive composition according to claim 1 or 2, **characterized in that** the oxetane compound is selected from the group consisting of 3-ethyl-3-(phenoxymethyl) oxetane and 3-(cyclohexyloxy) methyl-3-ethyl oxetane.

4. The photosensitive composition according to any one of claims 1 to 3, **characterized in that** it comprises a compound represented by the following chemical formula and 3-ethyl-3-(phenoxymethyl) oxetane:

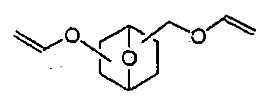

5. The photosensitive composition according to any one of claims 1 to 4, **characterized in that** it further comprises a powder.

6. The photosensitive composition according to claim 5, **characterized in that** the powder has magnetic property, fluorescent property, conductive property, insulating property, dielectric property or electromagnetic exothermic property.

7. The photosensitive composition according to claim 6, **characterized in that** the powder having a magnetic property is selected from iron oxide powder and ferromagnetic powder.

8. The photosensitive composition according to claim 6, **characterized in that** the powder having a fluorescent property is selected from inorganic fluorescence materials and organic fluorescence materials.

9. The photosensitive composition according to claim 6, **characterized in that** the powder having a conductive property is metal powder or metal oxide powder.

10. The photosensitive composition according to claim 6, **characterized in that** the powder having an insulating property is ceramic powder.

11. The photosensitive composition according to claim 6, **characterized in that** the powder having a dielectric property is selected from tantalum oxide powder and titanium oxide powder.

12. The photosensitive composition according to claim 5, **characterized in that** the powder is a filler selected from the oxides or nitrides of aluminium or silicon, silicon carbide, talc, and mica.

13. A composite member **characterized by** comprising:
a resin moiety (1, 8, 11, 26) which is formed of a cured material of the photosensitive composition claimed in any one of claims 1 to 12.

14. The composite member according to claim 13, **characterized by** comprising:
a metallic moiety (27); and
said resin moiety (26) which is contacted with the metallic moiety (27).

15. The composite member according to claim 13 in the form of an electronic part, **characterized by** comprising:
an insulating moiety (8) and a conductive moiety (11), at least one of the insulating moiety (8) and the conductive moiety (11) being said resin moiety.

## Patentansprüche

1. Lichtempfindliche Zusammensetzung, die
einen kationischen Photopolymerisationsinitiator und
ein organisches Dispersionsmedium umfasst, das mindestens eine Art von Oxetanverbindung, mindestens eine Art von Vinyletherverbindung, die durch die folgende allgemeine Formel (1) dargestellt ist, und eine Oxiranverbindung enthält, wobei mindestens eine der Oxetan-, Vinylether- und Oxiranverbindungen eine monofunktionelle Verbindung ist, wobei die monofunktionelle Oxetanverbindung eine Oxetanverbindung ist, die einen Oxetanring enthält, die monofunktionelle Vinyletherverbindung eine Vinyletherverbindung ist, die eine Vinylethergruppe enthält, und die monofunktionelle Oxiranverbindung eine Oxiranverbindung ist, die einen Oxiranring enthält,
R¹¹-R¹²-(R¹¹)ₚ (1)
wobei die R¹¹-Gruppen jeweils eine Gruppe sind, die aus der Gruppe, bestehend aus einer Vinylethergruppe, einer Gruppe, die ein Vinylether-Grundgerüst aufweist, einer Alkoxygruppe, einer substituierten Hydroxylgruppe und einer Hydroxylgruppe, ausgewählt ist, wobei mindestens eine R¹¹-Gruppe eine Vinylethergruppe oder eine Gruppe, die ein Vinylether-Grundgerüst aufweist, ist, R¹² eine (p+1)-wertige Gruppe mit einem substituierten oder unsubstituierten cyclischen Ether-Grundgerüst ist, und p eine positive ganze Zahl, einschließlich Null, ist, und
wobei die monofunktionelle Verbindung in dem organischen Dispersionsmedium mit einem Gehalt von 20 % oder mehr und 70 % oder weniger enthalten ist, bezogen auf das Gesamtgewicht des organischen Dispersionsmediums, die Vinyletherverbindung in dem organischen Dispersionsmedium mit einem Gehalt von nicht weniger als 30 Gew.-% enthalten ist, bezogen auf das Gesamtgewicht des organischen Dispersionsmediums, die Oxetanverbindung in dem organischen Dispersionsmedium mit einem Gehalt von 20 % oder mehr und 60 % oder weniger enthalten ist, bezogen auf das Gesamtgewicht des organischen Dispersionsmediums, und die Oxiranverbindung in dem organischen Dispersionsmedium mit einem Gehalt von nicht mehr als 30 % enthalten ist, bezogen auf das Gesamtgewicht des organischen Dispersionsmediums.

2. Lichtempfindliche Zusammensetzung nach Anspruch 1, **dadurch gekennzeichnet, dass** die Vinyletherverbindung eine der Verbindungen ist, die durch die nachstehenden chemischen Formeln dargestellt sind:

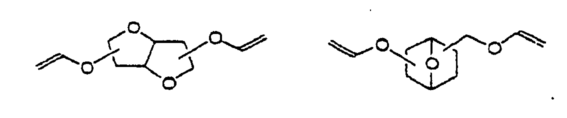

3. Lichtempfindliche Zusammensetzung nach Anspruch 1 oder 2, **dadurch gekennzeichnet, dass** die Oxetanverbindung aus der Gruppe, bestehend aus 3-Ethyl-3-(phenoxymethyl)oxetan und 3-(Cyclohexyloxy)methyl-3-ethyloxetan, ausgewählt ist.

4. Lichtempfindliche Zusammensetzung nach einem der Ansprüche 1 bis 3, **dadurch gekennzeichnet, dass** sie eine Verbindung, die durch die folgende chemische Formel dargestellt ist, und 3-Ethyl-3-(phenoxymethyl)oxetan umfasst:

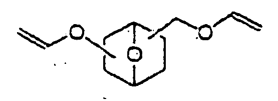

5. Lichtempfindliche Zusammensetzung nach einem der Ansprüche 1 bis 4, **dadurch gekennzeichnet, dass** sie ferner ein Pulver umfasst.

6. Lichtempfindliche Zusammensetzung nach Anspruch 5, **dadurch gekennzeichnet, dass** das Pulver magnetische Eigenschaften, Fluoreszenzeigenschaften, leitende Eigenschaften, Isoliereigenschaften, dielektrische Eigenschaften oder elektromagnetische, exotherme Eigenschaften aufweist.

7. Lichtempfindliche Zusammensetzung nach Anspruch 6, **dadurch gekennzeichnet, dass** das Pulver, das magnetische Eigenschaften aufweist, aus Eisenoxidpulver und ferromagnetischem Pulver ausgewählt ist.

8. Lichtempfindliche Zusammensetzung nach Anspruch 6, **dadurch gekennzeichnet, dass** das Pulver, das Fluoreszenzeigenschaften aufweist, aus anorganischen Fluoreszenzmaterialien und organischen Fluoreszenzmaterialien ausgewählt ist.

9. Lichtempfindliche Zusammensetzung nach Anspruch 6, **dadurch gekennzeichnet, dass** das Pulver, das leitende Eigenschaften aufweist, ein Metallpulver oder ein Metalloxidpulver ist.

10. Lichtempfindliche Zusammensetzung nach Anspruch 6, **dadurch gekennzeichnet, dass** das Pulver, das isolierende Eigenschaften aufweist, ein keramisches Pulver ist.

11. Lichtempfindliche Zusammensetzung nach Anspruch 6, **dadurch gekennzeichnet, dass** das Pulver, das dielektrische Eigenschaften aufweist, aus Tantaloxidpulver und Titanoxidpulver ausgewählt ist.

12. Lichtempfindliche Zusammensetzung nach Anspruch 5, **dadurch gekennzeichnet; dass** das Pulver ein Füllstoff ist, der aus den Oxiden oder Nitriden von Aluminium oder Silizium, Siliziumcarbid, Talk und Glimmer ausgewählt ist.

13. Verbundelement, **dadurch gekennzeichnet, dass** es umfasst:
ein Harzelement (1, 8, 11, 26), das aus einem gehärteten Material der lichtempfindlichen Zusammensetzung nach einem der Ansprüche 1 bis 12 gebildet ist.

14. Verbundelement nach Anspruch 13, **dadurch gekennzeichnet, dass** es umfasst:
ein metallisches Element (27) und
das Harzelement (26), das mit dem metallischen Element (27) in Kontakt ist.

15. Verbundelement nach Anspruch 13 in der Form eines elektronischen Bauteils, **dadurch gekennzeichnet, dass** es umfasst:
eine Isoliereinheit (8) und eine leitende Einheit (11), wobei mindestens eine der Isoliereinheit (8) und der leitenden Einheit (11) das Harzelement ist.

## Revendications

1. Composition photosensible comprenant :
un amorceur de photopolymérisation cationique ; et
un milieu de dispersion organique contenant au moins un type de composé oxétane, au moins un type de composé éther de vinyle représenté par la formule générale suivante (1) et un composé oxirane, au moins un des composés oxétane, éther de vinyle et oxirane étant un composé monofonctionnel, où le composé oxétane monofonctionnel est un composé oxétane contenant un cycle oxétane, le composé monofonctionnel éther de vinyle est un composé éther de vinyle contenant un groupe éther de vinyle et le composé oxirane monofonctionnel est un composé oxirane contenant un cycle oxirane,
R¹¹-R¹²-(R¹¹)ₚ (1)
où les R¹¹ sont individuellement un groupe sélectionné dans le groupe constitué d'un groupe éther de vinyle, un groupe portant un squelette éther de vinyle, un groupe alcoxy, un groupe hydroxyle substitué et un groupe hydroxyle, au moins un des R¹¹ étant un groupe éther de vinyle ou un groupe portant un squelette éther de vinyle ; R¹² est un groupe (p+1)-valent ayant un squelette éther cyclique substitué ou non substitué et p est un entier positif comprenant zéro, et
où le composé monofonctionnel est contenu dans le milieu de dispsersion organique à une teneur de 20 % ou plus et de 70 % ou moins par rapport au poids total du milieu de dispersion organique, le composé éther de vinyle est contenu dans le milieu de dispersion organique à une teneur supérieure ou égale à 30 % en poids par rapport au poids total du milieu de dispersion organique, le composé oxétane est contenu dans le milieu de dispersion organique à une teneur de 20 % ou plus et de 60 % ou moins par rapport au poids total du milieu de dispersion organique et le composé oxirane est contenu dans le milieu de dispersion organique à une teneur inférieure ou égale à 30 % par rapport au poids total du milieu de dispersion organique.

2. Composition photosensible selon la revendication 1, **caractérisée en ce que** le composé éther de vinyle est un des composés représentés par les formules chimiques suivantes :

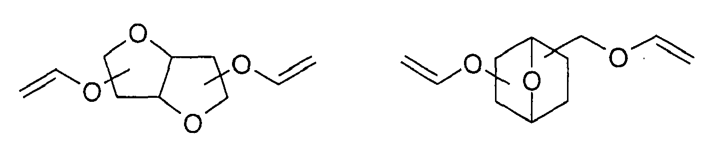

3. Composition photosensible selon la revendication 1 ou 2, **caractérisée en ce que** le composé oxétane est sélectionné dans le groupe constitué du 3-éthyl-3-(phénoxyméthyl)oxétane et du 3-(cyclohexyloxy)-méthyl-3-éthyloxétane.

4. Composition photosensible selon l'une quelconque des revendications 1 à 3, **caractérisée en ce qu'**elle comprend un composé représenté par la formule chimique suivante et du 3-éthyl-3-(phénoxyméthyl)oxétane :

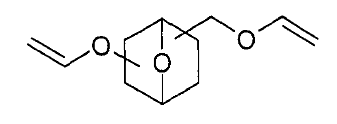

5. Composition photosensible selon l'une quelconque des revendications 1 à 4, **caractérisée en ce qu'**elle comprend en outre une poudre.

6. Composition photosensible selon la revendication 5, **caractérisée en ce que** la poudre a une propriété magnétique, une propriété de fluorescence, une propriété de conduction, une propriété d'isolement, une propriété diélectrique ou une propriété exothermique électromagnétique.

7. Composition photosensible selon la revendication 6, **caractérisée en ce que** la poudre ayant une propriété magnétique est sélectionnée parmi la poudre d'oxyde de fer et la poudre ferromagnétique.

8. Composition photosensible selon la revendication 6, **caractérisée en ce que** la poudre ayant une propriété de fluorescence est sélectionnée parmi des substances fluorescentes inorganiques et des substances fluorescentes organiques.

9. Composition photosensible selon la revendication 6, **caractérisée en ce que** la poudre ayant une propriété de conduction est la poudre de métal ou la poudre d'oxyde de métal.

10. Composition photosensible selon la revendication 6, **caractérisée en ce que** la poudre ayant une propriété d'isolement est la poudre céramique.

11. Composition photosensible selon la revendication 6, **caractérisée en ce que** la poudre ayant une propriété diélectrique est sélectionnée parmi la poudre d'oxyde de tantale et la poudre d'oxyde de titane.

12. Composition photosensible selon la revendication 5, **caractérisée en ce que** la poudre est une charge sélectionnée parmi les oxydes ou les nitrures d'aluminium ou de silicium, le carbure de silicium, le talc et le mica.

13. Elément composite **caractérisé en ce qu'**il comprend :
une fraction de résine (1, 8, 11, 26) formée d'un matériau durci de la composition photosensible selon l'une quelconque des revendications 1 à 12.

14. Elément composite selon la revendication 13, **caractérisé en ce qu'**il comprend :
une fraction métallique (27) ; et
ladite fraction de résine (26) qui est mise en contact avec la fraction métallique (27).

15. Elément composite selon la revendication 13 sous la forme d'une pièce électronique, **caractérisé en ce qu'**il comprend :
une fraction isolante (8) et une fraction conductrice (11), au moins la fraction isolante (8) ou la fraction conductrice (11) étant ladite fraction de résine.
